(19) Europäisches Patentamt / European Patent Office / Office européen des brevets

(11) **EP 2 509 222 B1**

(12) # FASCICULE DE BREVET EUROPEEN

(45) Date de publication et mention
de la délivrance du brevet:
**04.06.2014 Bulletin 2014/23**

(51) Int Cl.:
***H04B 1/04*** (2006.01)

(21) Numéro de dépôt: **12161977.9**

(22) Date de dépôt: **29.03.2012**

(54) **Chaîne d'émission ou réception radiofréquence à adaptation automatique d'impédance et procédé correspondant**

Funkemissions- oder Empfangskette mit automatischer Impedanzanpassung, und entsprechendes Verfahren

Channel for radio-frequency transmission or reception, with automatic impedance matching and corresponding method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.04.2011 FR 1153033**

(43) Date de publication de la demande:
**10.10.2012 Bulletin 2012/41**

(73) Titulaire: **COMMISSARIAT A L'ENERGIE ATOMIQUE ET AUX ENERGIES ALTERNATIVES**
**75015 Paris (FR)**

(72) Inventeurs:
• **El Kaamouchi, Majid**
**94440 Villecresnes (FR)**
• **David, Jean-Baptiste**
**38000 Grenoble (FR)**
• **De Foucauld, Emeric**
**38500 Voiron (FR)**

(74) Mandataire: **Guérin, Michel et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A1-96/39727      US-A- 4 612 669**

• **FIRRAO E L ET AL: "An Automatic Antenna Tuning System Using Only RF Signal Amplitudes", IEEE TRANSACTIONS ON CIRCUITS AND SYSTEMS II: EXPRESS BRIEFS, IEEE, US, vol. 55, no. 9, 1 septembre 2008 (2008-09-01), pages 833-837, XP011232645, ISSN: 1549-7747, DOI: 10.1109/TCSII.2008.925652**
• **VAN BEZOOIJEN A ET AL: "Adaptive Impedance-Matching Techniques for Controlling L Networks", IEEE TRANSACTIONS ON CIRCUITS AND SYSTEMS I: REGULAR PAPERS, IEEE, US, vol. 57, no. 2, 1 février 2010 (2010-02-01), pages 495-505, XP011333613, ISSN: 1549-8328, DOI: 10.1109/TCSI.2009.2023764**

**Description**

L'invention concerne la réalisation d'un circuit d'adaptation automatique d'impédance d'antenne radio.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

Une chaîne d'émission (respectivement de réception) comprend au moins un amplificateur auquel peuvent être associés un ou plusieurs filtres.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi on a déjà essayé d'interposer entre la sortie de la chaîne d'émission et l'antenne d'émission (et on pourrait le faire aussi en entrée pour une antenne de réception) un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances.

Dans la demande de brevet US 2009-0066440, on a proposé un procédé d'adaptation automatique d'impédance dans une chaîne d'émission ou de réception, dans lequel on détecte à la fois l'amplitude et la phase du courant et de la tension en sortie de la chaîne d'émission (ou en entrée de la chaîne de réception). Le rapport entre la tension et le courant est représentatif de l'impédance de charge Zm vue par la chaîne chargée par l'ensemble du réseau d'adaptation et de l'antenne d'impédance $Z_{ant}$. On mesure l'impédance de charge Zm et on calcule l'impédance d'antenne $Z_{ant}$ à partir de l'impédance de charge mesurée Zm et des impédances du réseau d'adaptation dont la configuration est connue au moment de la mesure, et enfin on calcule la modification qu'il faut appliquer à une ou plusieurs des impédances du réseau d'adaptation, pour obtenir que l'impédance vue par l'amplificateur devienne adaptée à l'impédance nominale de l'amplificateur dans les conditions actuelles d'environnement de l'antenne.

Dans des applications où il suffit de faire une fois l'adaptation d'impédance, ou dans des applications où on peut se contenter de faire l'adaptation à chaque nouvelle mise en route de la chaîne d'émission ou de réception, ce procédé fonctionne bien.

Mais dans d'autres applications, il arrive que l'environnement de l'antenne change en cours d'utilisation de la chaîne et nécessite une nouvelle adaptation sans attendre un arrêt et une nouvelle mise en route. C'est le cas par exemple dans un téléphone portable dont l'environnement peut changer alors qu'il est allumé (au moins en veille) et même alors qu'une conversation téléphonique est en cours. Pour ces applications, on souhaite faire une adaptation immédiate entre l'impédance de l'antenne et l'impédance du circuit d'émission ou du circuit de réception.

Le circuit de la demande de brevet précitée ne permet pas vraiment de le faire sans interaction gênante entre la chaîne d'émission/réception et les moyens de calcul d'adaptation.

Pour permettre une adaptation immédiate des impédances, l'invention propose une chaîne d'émission ou de réception radiofréquence travaillant à une fréquence nominale $F_0$, comportant au moins un amplificateur, une antenne, un réseau d'adaptation d'impédance disposé entre l'amplificateur et l'antenne et comprenant des impédances ajustables, une impédance de mesure de valeur complexe connue insérée en série entre l'amplificateur et le réseau d'adaptation, des moyens de mesure des potentiels présents aux bornes de l'impédance de mesure pour déterminer à la fois le courant dans l'impédance de mesure et une tension en sortie de l'amplificateur pour une chaîne d'émission ou une tension en entrée de l'amplificateur pour une chaîne de réception, des moyens de calcul (DSP)

- de l'impédance complexe définie par le rapport entre la tension et le courant, cette impédance complexe représentant une impédance de charge ou d'entrée actuelle de l'amplificateur,
- d'une impédance de l'antenne,

- et de nouvelles valeurs des impédances ajustables du réseau d'adaptation qui permettent d'obtenir une impédance de charge ou d'entrée désirée pour l'amplificateur,

et des moyens de commande électrique du réseau d'adaptation pour ajuster les impédances ajustables à ces nouvelles valeurs, cette chaîne étant **caractérisée en ce qu'**elle comporte un générateur de fréquence de mesure relié à la sortie de l'amplificateur d'émission ou à l'entrée de l'amplificateur d'émission, pour y injecter une fréquence de mesure $F_m$ différente de la fréquence de travail $F_0$, les moyens de calcul des impédances du réseau d'adaptation étant agencés pour faire des calculs d'impédance à partir de tensions et courants mesurés à la fréquence $F_m$, en appliquant ensuite une correction pour ramener les impédances calculées aux valeurs qu'elles auraient pour la fréquence $F_0$.

Un filtre passe-bande est de préférence incorporé au générateur de fréquence $F_m$ ou placé immédiatement en aval de ce dernier pour ne laisser passer que la fréquence de mesure $F_m$ vers le reste de la chaîne et pour empêcher le passage de signaux à la fréquence $F_0$ vers le générateur.

Un filtre coupe-bande de caractéristiques d'impédance connues peut être inséré entre l'amplificateur et l'impédance de mesure pour éviter le passage vers l'amplificateur de signaux à la fréquence $F_m$. Dans ce cas, le calcul de l'impédance de charge ou d'entrée actuelle de l'amplificateur tient compte si nécessaire des caractéristiques d'impédances connues du filtre.

Les moyens de mesure de potentiels comprennent de préférence un circuit de transposition de fréquence avec un oscillateur local à fréquence $F_{OL}$ pour transposer la fréquence de mesure $F_m$ à une fréquence intermédiaire $F_{IF} = F_m - F_{OL}$ et un filtre passe-bas laissant passer la fréquence $F_{IF}$ mais pas la fréquence $F_0 - F_{OL}$.

Le réseau d'adaptation peut être constitué d'un montage simple à trois impédances réactives en Té ou en Pi, par exemple une capacité et deux inductances ou mieux une inductance et deux capacités. Au moins une de ces impédances est variable mais en pratique deux des impédances seront variables. De préférence on utilisera deux capacités variables et une inductance fixe en considérant qu'il est plus facile de réaliser des capacités variables précises que des inductances variables. Le réseau d'adaptation peut aussi avoir plusieurs étages en cascade si la désadaptation risque d'être particulièrement forte. Dans ce cas, chaque étage peut être constitué par un montage simple à trois impédances réactives en Té ou en Pi avec en principe deux impédances réactives variables dans chaque étage.

Outre la chaîne d'émission ou réception qui fait l'objet de cette invention, l'invention concerne corrélativement un procédé d'adaptation automatique d'impédance qui est **caractérisé en ce que** l'on injecte dans la chaîne une fréquence de mesure $F_m$ différente de la fréquence de travail, on effectue les mesures de potentiels à cette fréquence, et on fait les calculs d'impédance à partir de ces mesures en appliquant une correction pour ramener les impédances calculées aux valeurs qu'elles auraient pour la fréquence $F_0$.

D'autres caractéristiques et avantages de l'invention apparaîtront à la lecture de la description détaillée qui suit et qui est faite en référence aux dessins annexés dans lesquels :

- la figure 1 représente la constitution générale d'une chaîne d'émission radiofréquence comportant des moyens d'adaptation automatique d'impédance ;
- la figure 2 représente la constitution d'une chaîne d'émission et/ou réception selon l'invention ;
- la figure 3 représente un gabarit de fréquences montrant une fréquence de mesure en dehors de la bande de fréquences dans laquelle la chaîne peut fonctionner ;
- la figure 4 représente la chaîne selon l'invention, plus détaillée, dans une configuration différentielle ;
- la figure 5 représente le gabarit d'un filtre de signaux à fréquence intermédiaire utilisé dans la chaîne.

Dans la description détaillée qui suit, on considérera essentiellement que l'antenne est une antenne d'émission alimentée par la sortie d'un amplificateur. L'amplificateur est conçu pour fonctionner de manière optimale lorsque la charge placée à sa sortie a une impédance nominale $Z_{opt}$ et lorsque la fréquence de fonctionnement est $F_0$, correspondant à une pulsation $\omega_0 = 2\pi.F_0$. A haute fréquence, l'impédance $Z_{opt}$ sera généralement complexe. L'invention est applicable de la même manière si l'antenne est une antenne de réception connectée à l'entrée d'un amplificateur conçu pour fonctionner de manière optimale lorsque l'impédance connectée à son entrée est une impédance nominale $Z_{opt}$ et lorsque la fréquence de fonctionnement est $F_0$.

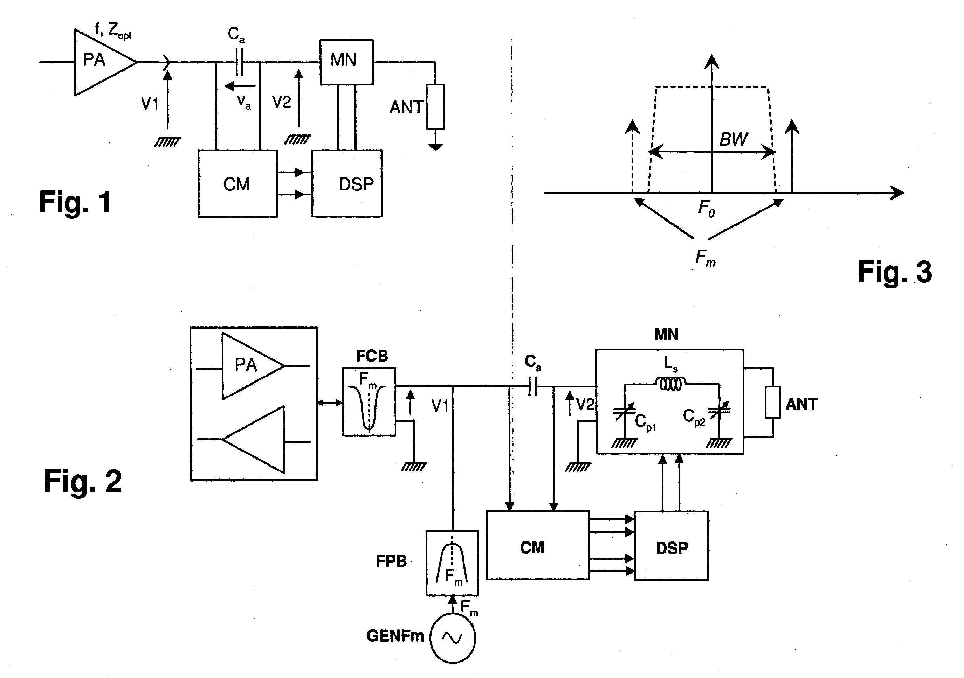

La figure 1 représente un schéma de principe de circuit d'émission radiofréquence, avec un amplificateur PA travaillant à la fréquence porteuse d'émission $F_0$, une antenne ANT alimentée par l'amplificateur, un réseau d'adaptation MN inséré en série entre la sortie de l'amplificateur PA et l'antenne ANT. Ce schéma pourrait aussi inclure un filtre entre l'amplificateur PA et le réseau MN et/ou un filtre entre le réseau MN et l'antenne.

Le réseau d'adaptation MN est inclus dans un circuit d'adaptation automatique d'impédance dont la fonction est de faire en sorte que l'impédance de la charge de l'amplificateur soit égale à l'impédance optimale $Z_{opt}$ de l'amplificateur ou la plus proche possible de cette impédance optimale. La charge de l'amplificateur est essentiellement constituée par le réseau MN, lui-même chargé par l'antenne ANT.

Outre le réseau MN, le circuit d'adaptation comprend :

- une impédance de mesure placée en série entre la sortie de l'amplificateur et le réseau d'adaptation MN ; elle sert à la mesure du courant i qui sort de l'amplificateur ; cette impédance est de préférence une simple capacité $C_a$ d'impédance $1/j.C_a.\omega_0$ ; la tension à ses bornes est une tension $v_a = i/j.C_a.\omega_0$ ; le courant est $i = j.v_a.C_a.\omega_0$ ;

- un circuit de mesure CM des potentiels V1 et V2 présents sur les bornes de l'impédance de mesure, en valeurs complexes, c'est-à-dire incluant la valeur du déphasage entre ces potentiels ; Va est égal à V1-V2 ;

- des moyens de calcul DSP qui permettent de calculer mathématiquement, à partir de ces valeurs complexes V1 et V2, quelles valeurs d'impédances il faut donner aux impédances du réseau d'adaptation MN pour réaliser une adaptation entre l'impédance de sortie de l'amplificateur et l'impédance de la charge appliquée à cette sortie.

Les moyens de calcul DSP fournissent, directement ou par l'intermédiaire d'un circuit logique de commande, des signaux de commande de commutateurs non représentés qui font partie du réseau MN et qui établissent les valeurs d'impédances désirées pour chaque impédance de ce réseau.

La publication de brevet US2009-0066440 décrit la manière dont fonctionne le circuit d'adaptation. En résumé, les moyens de calcul DSP calculent le module et l'argument de l'impédance $Zm = V1/i$ de la charge actuelle de l'amplificateur à partir de la tension V1 et du courant i, ce dernier étant obtenu à partir de la tension Va ; ils calculent à partir de là l'impédance vectorielle Zm en partie réelle et partie imaginaire ; ils calculent l'impédance effective de l'antenne $Z_{ant}$ à partir de ces valeurs et des valeurs d'impédance actuelles connues des différentes impédances Z1, Z2, etc. qui constituent le réseau d'adaptation MN ; ils calculent une ou plusieurs valeurs d'impédances modifiées Z'1, Z'2 du réseau d'adaptation MN à partir d'une valeur désirée $Z_{opt}$ de l'impédance de charge de l'amplificateur et à partir de l'impédance d'antenne calculée $Z_{ant}$, et enfin ils fournissent au réseau MN les signaux de commande appropriés pour donner aux impédances Z1, Z2, etc. de ce réseau les valeurs modifiées Z'1, Z'2, etc. ainsi calculées. La chaîne d'émission et de réception est adaptée lorsque les impédances du réseau d'adaptation prennent ces valeurs calculées Z'1, Z'2, etc.

Selon l'invention, on propose de modifier la chaîne d'émission ou de réception en y rajoutant un générateur de fréquence fournissant un signal sinusoïdal à une fréquence de mesure $F_m$ qui est différente de la fréquence de travail $F_0$ de la chaîne d'émission ou de réception. La fréquence de mesure $F_m$ est située en dehors de la bande passante de la chaîne. Cette bande passante est liée à l'utilisation envisagée pour la chaîne et elle est déterminée par les filtres non représentés présents à différents niveaux de la chaîne.

La figure 2 représente la chaîne d'émission et/ou de réception qui en résulte. On considérera principalement qu'il s'agit d'une chaîne d'émission avec un amplificateur PA destiné à fournir des signaux radiofréquence à l'antenne.

Le générateur de fréquence de mesure est désigné par GENFm. C'est un oscillateur qui peut être stabilisé par un quartz.

La sortie du générateur est appliquée à un filtre passe-bande FPB centré sur la fréquence $F_m$ et dont le rôle est de laisser passer seulement la fréquence $F_m$ en sortie du générateur pour ne pas perturber la chaîne d'émission par des parasites, par exemple des harmoniques qui pourraient venir du générateur. La sortie de ce filtre est connectée à la sortie de l'amplificateur PA. Le filtre FPB peut être incorporé au générateur.

Le rôle du générateur GENFm est d'injecter une fréquence de mesure dans la chaîne d'émission vers la capacité de mesure, le réseau d'adaptation et l'antenne. Un filtre coupe-bande FCB, laissant passer la fréquence de travail $F_0$ de la chaîne mais coupant la fréquence de mesure $F_m$ est interposé entre l'amplificateur PA et la capacité de mesure $C_a$ de manière que le signal à la fréquence de mesure $F_m$ ne parte pas vers l'amplificateur mais parte vers la capacité de mesure, le réseau d'adaptation MN et l'antenne ANT.

Pour le reste, la chaîne d'émission ou réception de la figure 2 comporte un circuit de mesure de tension CM et un processeur de calcul DSP comme à la figure 1. La différence est que le circuit de mesure est conçu pour fonctionner à la fréquence $F_m$ et le processeur de calcul effectue des calculs d'impédances qui tiennent compte du fait que la fréquence à laquelle sont mesurés les potentiels aux bornes de la capacité de mesure est $F_m$.

Sur la figure 2 on a considéré que la mesure des potentiels sur les bornes des capacités est faite par la mesure et la conversion analogique-numérique de deux tensions V1 et V2 à fréquence $F_m$, sachant qu'on aurait pu aussi bien considérer qu'on fait la mesure et la conversion de la tension V1 et de la tension V1-V2, ou encore de la tension V2 et de la tension V1-V2, ces trois types de mesure étant équivalentes pour le but recherché.

L'impédance de charge Zm de l'amplificateur (excluant le filtre coupe-bande FCB) est constituée par l'ensemble en série comprenant l'impédance de la capacité $C_a$, et l'impédance globale du réseau MN chargé par l'antenne. Cette impédance de charge Zm est égale à V1/i si i est le courant dans la capacité ; le courant est $(V1-V2)jC_a.\omega_m$ où $\omega_m$ est la pulsation $(2\pi F_m)$ à la fréquence $F_m$.

L'impédance de charge à la fréquence Fm est donc

$$Zm = V1.jC_a.\omega_m/(V1-V2)$$

Le réseau d'adaptation comporte des capacités et des inductances. Les valeurs de ces capacités et inductances sont connues du processeur de calcul DSP qui impose leur valeur à un moment donné. La configuration du réseau d'adaptation MN est également connue, par exemple une configuration en Pi avec deux capacités variables $C_{p1}$, $C_{p2}$ et une inductance fixe $L_s$. Les impédances des inductances sont proportionnelles à la fréquence ; les impédances des capacités sont inversement proportionnelles à la fréquence.

Le processeur de calcul connaît donc à la fois

- l'impédance de charge globale Zm en sortie du filtre coupe-bande,
- et la valeur des impédances en aval de ce filtre : impédance de la capacité de mesure $C_a$, impédances du réseau d'adaptation, mais pas l'impédance de l'antenne qui est inconnue.

A partir de là, le processeur DSP peut calculer l'impédance de l'antenne à la fréquence $F_m$. Il s'agit d'une impédance complexe qui est a priori capacitive. On peut faire l'hypothèse que la partie imaginaire de l'impédance de l'antenne est inversement proportionnelle à la fréquence (ou bien que la partie imaginaire de l'admittance de l'antenne est proportionnelle à la fréquence).

Le processeur en déduit la valeur supposée de l'impédance ou l'admittance de l'antenne à la fréquence de travail $F_0$ : même partie réelle qu'à la fréquence $F_m$, partie imaginaire de l'admittance multipliée par le rapport $F_0/F_m$. On peut également, pour plus de précision, utiliser une antenne qui a été préalablement caractérisée et dont on connaît la correspondance entre l'impédance à la fréquence de mesure $F_m$ et l'impédance à la fréquence de travail $F_0$. Dans ce cas, le calcul de l'impédance à la fréquence $F_m$ permet d'obtenir, par une table de correspondance, l'impédance à la fréquence $F_0$. Cette dernière méthode permet de relâcher les contraintes de proximité entre la fréquence $F_m$ et la fréquence $F_0$ et donc de faciliter la réalisation des filtres nécessaires dans le circuit de mesure.

Le processeur DSP calcule alors, à partir des impédances connues calculées à la fréquence de travail $F_0$, et cette fois en connaissant l'impédance de l'antenne à la fréquence $F_0$, quelles valeurs d'impédances il faut donner aux impédances variables (de préférence les capacités) du réseau MN pour que la charge en sortie de l'amplificateur ait une impédance optimale à la fréquence $F_0$.

Le processeur impose les valeurs de capacité ou d'inductance correspondant à ce calcul au réseau MN.

On suppose pour ces calculs que le filtre coupe-bande FCB ne produit ni atténuation ni déphasage à la fréquence $F_0$. On suppose également qu'il a une impédance infinie à la fréquence $F_m$. Si ce n'était pas le cas, il faudrait en tenir compte dans le calcul des impédances à donner au réseau pour aboutir à une charge ayant une impédance optimale à la fréquence $F_0$ en sortie de l'amplificateur PA.

De même, on suppose que le filtre passe-bande FPB a une impédance infinie à la fréquence $F_0$ et qu'il ne perturbe donc pas l'impédance de charge de l'amplificateur à cette fréquence. Si ce n'était pas le cas il faudrait en tenir compte dans le calcul.

La figure 3 représente la bande de fréquence attribuée à la chaîne d'émission, c'est-à-dire la bande dans laquelle elle doit pouvoir fonctionner. Pour que la mesure ne perturbe pas la chaîne si elle est faite pendant le fonctionnement normal de la chaîne, il faut que la fréquence de mesure $F_m$ soit en dehors de cette bande BW, la fréquence de travail $F_0$ étant comprise dans cette bande et pouvant être par exemple vers le milieu. La fréquence de mesure peut être supérieure ou inférieure à la bande de fréquences BW.

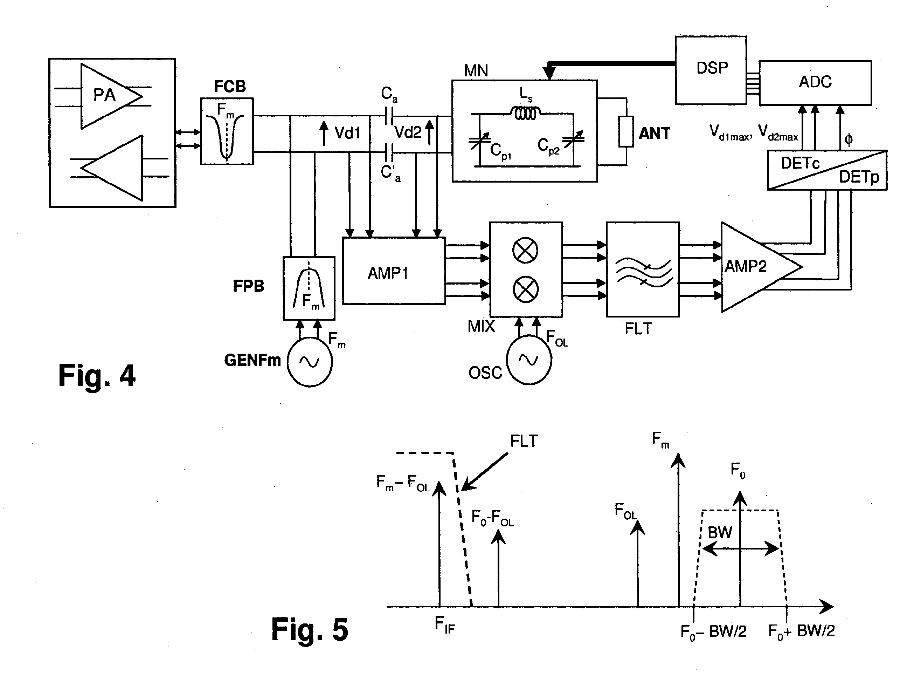

La figure 4 représente une configuration plus détaillée de la partie de la chaîne qui sert au calcul d'adaptation. Cette partie est représentée dans le cas où la chaîne fonctionne en différentiel en amont du réseau d'adaptation MN.

Les sorties de l'amplificateur (ou les entrées dans le cas d'une chaîne de réception) sont différentielles, de même que les entrées et sorties du filtre FCB, celles du générateur GENFm, celles du filtre FPB, et bien sûr aussi les entrées du circuit de mesure des tensions V1 et V2 qui sont maintenant différentielles et désignées par Vd1 et Vd2 au lieu de V1 et V2. La capacité de mesure est divisée en deux capacités $C_a$, $C'_a$ identiques.

Le circuit de mesure qui reçoit les tensions Vd1 et Vd2 comprend essentiellement un amplificateur tampon AMP1 ayant de préférence un gain unitaire et une impédance d'entrée infinie (à la fréquence $F_m$ et à la fréquence $F_0$) pour ne pas perturber la mesure ni le fonctionnement de la chaîne.

La sortie de l'amplificateur applique les tensions différentielles Vd1 et Vd2 à un mélangeur MIX associé à un oscillateur local OSC à fréquence $F_{OL}$. Le mélangeur transpose la fréquence de mesure $F_m$ (assez proche de $F_0$) à une fréquence intermédiaire $F_{IF} = F_m - F_{OL}$ beaucoup plus basse.

Un filtre passe-bas FLT est placé en sortie du mélangeur pour ne conserver les signaux de mesure Vd1 et Vd2 que dans une bande de fréquences étroite autour de la différence $F_m - F_{OL}$, en rejetant bien sûr les fréquences autour de $F_0 + F_{OL}$, mais surtout en rejetant la différence $F_0 - F_{OL}$ qui peut perturber la mesure.

La transposition de fréquence peut se faire jusqu'à obtenir les signaux Vd1 et Vd2 en bande de base (fréquence intermédiaire nulle pour les signaux de mesure).

Les tensions transposées Vd1 et Vd2 et filtrées sont amplifiées dans un amplificateur AMP2 à fréquence intermédiaire. De là elles sont appliquées à la fois à un détecteur de crête DETc pour en détecter l'amplitude maximale $Vd1_{max}$ et $Vd2_{max}$ et à un détecteur de phase DETp pour déterminer la différence de phase entre Vd1 et Vd2. Le détecteur de phase convertit le déphasage en une tension continue proportionnelle au déphasage. Les valeurs maximales et les valeurs de phase sont converties en numérique dans un convertisseur analogique-numérique ADC. Ce convertisseur fournit les valeurs d'amplitude et de phase numérisées au processeur de calcul DSP pour que celui-ci puisse d'abord déterminer l'impédance globale en sortie de l'amplificateur PA puis en déduire les impédances à donner au réseau d'adaptation pour une adaptation optimale à l'impédance de sortie de l'amplificateur PA.

La figure 5 représente le gabarit du filtre FLT. Ce gabarit doit permettre le passage de signaux à la fréquence $F_m$-$F_{OL}$ mais il ne doit pas laisser passer des signaux autour de la fréquence $F_0$-$F_{OL}$.

Dans le cas d'un réseau d'adaptation en Pi avec une inductance $L_s$ en série entre deux capacités en parallèle $C_{p1}$ et $C_{p2}$, le calcul de l'impédance de l'antenne à la fréquence $F_0$ peut se faire en particulier de la manière suivante si Vd1 et Vd2 ont une amplitude $Vd1_{max}$ et $Vd2_{max}$ respectivement avec un déphasage $\phi$ de Vd1 par rapport à Vd2 à la fréquence $F_m$ :

on appelle $\lambda$ le rapport $[Vd1_{max}/Vd2_{max}].e^{\phi}$
on appelle $\omega$ la pulsation à la fréquence $F_0$, $\omega_0 = 2\pi F_0$
l'admittance de l'antenne est alors :

$$Y_{ant} = j [(1/A1) - \omega_0 C_{p2}]$$

avec

$$avec\ A1 = [(1/B1) + L_s\omega_0]$$

avec

$$avec\ B1 = \omega_0[(\lambda-1)C_a - C_{p1}]$$

L'invention permet de faire la mesure sans prélever de puissance du signal utile à fréquence $F_0$. De plus, la fréquence de mesure $F_m$ est indépendante de la fréquence de travail, de sorte que même si la fréquence de travail change, on peut conserver le même oscillateur local pour la transposition de fréquence en vue de la conversion analogique-numérique.

La puissance du signal de mesure n'influe pas sur la mesure, et cette puissance peut donc être choisie de manière à éviter toute saturation (dans le cas d'une chaîne d'émission). Le signal de mesure peut donc être parfaitement sinusoïdal, ce qui est très souhaitable pour le calcul des impédances.

Dans le cas d'une chaîne de réception, on n'est pas gêné par le risque que le signal à fréquence $F_0$ soit trop faible pour permettre une mesure.

A titre d'exemple, on a mis en oeuvre les principes de l'invention avec les données suivantes :

Fréquence centrale $F_0$ = 2,44 GHz (standard ISM)
Fréquence de mesure Fm = 2,40 GHz
Fréquence d'oscillateur local $F_{OL}$ = 2,395 GHz
(fréquence intermédiaire 5 MHz)

Le filtre en sortie du mélangeur est calibré pour laisser passer les signaux à 5 MHz tout en coupant fortement l'amplitude de la fréquence $F_0$-$F_{OL}$ à 45 MHz.

On notera finalement que le circuit proposé permet également la détermination de l'impédance de sortie (pour une chaîne d'émission) de l'amplificateur de puissance, ou l'impédance d'entrée de l'amplificateur à faible bruit (pour une chaîne de réception). Dans ce cas, on supprime le filtre coupe-bande.

**Revendications**

1. Chaîne d'émission ou de réception radiofréquence travaillant à une fréquence nominale $F_0$, comportant au moins un amplificateur (PA), une antenne (ANT), un réseau d'adaptation d'impédance (MN) disposé entre l'amplificateur et l'antenne et comprenant des impédances ajustables, une impédance de mesure ($C_a$) de valeur complexe connue insérée en série entre l'amplificateur et le réseau d'adaptation, des moyens de mesure (CM) des potentiels (V1, V2) présents aux bornes de l'impédance de mesure pour déterminer à la fois le courant dans l'impédance de mesure et une tension en sortie de l'amplificateur pour une chaîne d'émission ou une tension en entrée de l'amplificateur pour une chaîne de réception, des moyens de calcul (DSP)

    - de l'impédance complexe définie par le rapport entre la tension et le courant, cette impédance complexe représentant une impédance de charge ou d'entrée actuelle de l'amplificateur,
    - d'une impédance de l'antenne
    - et de nouvelles valeurs des impédances ajustables du réseau d'adaptation qui permettent d'obtenir une impédance de charge ou d'entrée désirée pour l'amplificateur,

    et des moyens de commande électrique du réseau d'adaptation pour ajuster les impédances ajustables à ces nouvelles valeurs, cette chaîne étant **caractérisée en ce qu'**elle comporte un générateur de fréquence de mesure (GENFm) relié à la sortie de l'amplificateur d'émission ou à l'entrée de l'amplificateur d'émission, pour y injecter une fréquence de mesure $F_m$ différente de la fréquence de travail $F_0$, les moyens de calcul étant agencés pour faire des calculs d'impédance à partir de tensions et courants mesurés à la fréquence $F_m$, en appliquant ensuite une correction pour ramener les impédances calculées aux valeurs qu'elles auraient pour la fréquence $F_0$.

**2.** Chaîne d'émission ou de réception selon la revendication 1, **caractérisée en ce qu'**elle comporte un filtre passe-bande (FPB) incorporé au générateur de fréquence ou placé immédiatement en aval de ce dernier pour ne laisser passer que la fréquence de mesure $F_m$ vers le reste de la chaîne et pour empêcher le passage de signaux à la fréquence $F_0$ vers le générateur.

**3.** Chaîne d'émission ou de réception selon l'une des revendications 1 et 2, **caractérisée en ce qu'**elle comporte un filtre coupe-bande (FCB) de caractéristiques d'impédance connues inséré entre l'amplificateur (PA) et l'impédance de mesure ($C_a$) pour éviter le passage vers l'amplificateur de signaux à la fréquence $F_m$.

**4.** Chaîne d'émission ou de réception selon l'une des revendications 1 à 3, **caractérisée en ce que** les moyens de mesure de potentiels comprennent un circuit de transposition de fréquence avec un oscillateur local (OSC) à fréquence $F_{OL}$ pour transposer la fréquence de mesure $F_m$ à une fréquence intermédiaire $F_{IF} = F_m - F_{OL}$ et un filtre passe-bas (FLT) laissant passer la fréquence $F_{IF}$ mais pas la fréquence $F_0 - F_{OL}$.

**5.** Procédé d'adaptation automatique d'impédance d'une chaîne d'émission ou de réception radiofréquence travaillant à une fréquence nominale $F_0$ et comportant au moins un amplificateur (PA), une antenne (ANT), un réseau d'adaptation d'impédance (MN) disposé entre l'amplificateur et l'antenne et comprenant des impédances ajustables, une impédance de mesure ($C_a$) de valeur complexe connue insérée en série entre l'amplificateur et le réseau d'adaptation, des moyens de mesure (CM) des potentiels (V1, V2) présents aux bornes de l'impédance de mesure pour déterminer à la fois le courant dans l'impédance de mesure et une tension en sortie de l'amplificateur pour une chaîne d'émission ou une tension en entrée de l'amplificateur pour une chaîne de réception, des moyens de calcul (DSP)

    - de l'impédance complexe définie par le rapport entre la tension et le courant, cette impédance complexe représentant une impédance de charge ou d'entrée actuelle de l'amplificateur,
    - d'une impédance de l'antenne
    - et de nouvelles valeurs des impédances ajustables du réseau d'adaptation qui permettent d'obtenir une impédance de charge ou d'entrée désirée pour l'amplificateur,

et des moyens de commande électrique du réseau d'adaptation pour ajuster les impédances ajustables à ces nouvelles valeurs,
procédé **caractérisé en ce que** l'on injecte dans la chaîne une fréquence de mesure $F_m$ différente de la fréquence de travail, on effectue les mesures de potentiels à cette fréquence, et on fait les calculs d'impédance à partir de ces mesures en appliquant une correction pour ramener les impédances calculées aux valeurs qu'elles auraient pour la fréquence $F_0$.

## Patentansprüche

**1.** Funkfrequenzemissions- oder -empfangskette, die mit einer Nennfrequenz $F_0$ arbeitet, die wenigstens Folgendes umfasst: einen Verstärker (PA), eine Antenne (ANT), ein Impedanzanpassungsnetz (MN), das zwischen dem Verstärker und der Antenne angeordnet ist und justierbare Impedanzen umfasst, eine Messimpedanz ($C_a$) mit einem bekannten komplexen Wert, die in Serie zwischen dem Verstärker und dem Anpassungsnetz geschaltet ist, Mittel (CM) zum Messen von Potentialen (V1, V2), die an den Anschlüssen der Messimpedanz anliegen, um gleichzeitig den Strom in der Messimpedanz und eine Spannung am Ausgang des Verstärkers für eine Emissionskette oder eine Spannung am Eingang des Verstärkers für eine Empfangskette zu ermitteln, Mittel (DSP) zum Berechnen:

    - der komplexen Impedanz, die durch das Verhältnis zwischen der Spannung und dem Strom definiert wird, wobei diese komplexe Impedanz eine aktuelle Ladungs- oder Eingangsimpedanz des Verstärkers repräsentiert,
    - einer Impedanz der Antenne,
    - und von neuen Werten der justierbaren Impedanzen des Anpassungsnetzes, mit denen eine gewünschte Ladungs- oder Eingangsimpedanz für den Verstärker erhalten werden kann,

und Mittel zum elektrischen Steuern des Anpassungsnetzes zum Justieren der justierbaren Impedanzen auf diese neuen Werte, wobei diese Kette **dadurch gekennzeichnet ist, dass** sie einen Messfrequenzgenerator (GENFm) umfasst, der mit dem Ausgang des Emissionsverstärkers oder mit dem Eingang des Emissionsverstärkers verbunden ist, um dort eine Messfrequenz $F_m$ zu injizieren, die sich von der Arbeitsfrequenz $F_0$ unterscheidet, wobei die Rechenmittel die Aufgabe haben, Impedanzberechnungen auf der Basis von auf der Frequenz $F_m$ gemessenen Spannungen und Strömen durchzuführen, unter nachfolgender Anwendung einer Korrektur, um die berechneten Impedanzen auf die Werte zu bringen, die sie für die Frequenz $F_0$ hätten.

**2.** Emissions- oder Empfangskette nach Anspruch 1, **dadurch gekennzeichnet, dass** sie ein Bandpassfilter (FPB) umfasst, das in den Frequenzgenerator integriert oder unmittelbar unterhalb desselben platziert ist, um sicherzustellen, dass er nur die Messfrequenz $F_m$ zum Rest der Kette durchlässt, und um die Passage von Signalen auf der Frequenz $F_0$ zum Generator zu verhüten.

3. Emissions- oder Empfangskette nach einem der Ansprüche 1 und 2, **dadurch gekennzeichnet, dass** sie ein Bandsperrfilter (FCB) mit bekannten Impedanzkennwerten hat, das zwischen dem Verstärker (PA) und der Messimpedanz ($C_a$) eingeführt wurde, um die Passage von Signalen auf der Frequenz $F_m$ zum Verstärker zu verhindern.

4. Emissons- oder Empfangskette nach einem der Ansprüche 1 bis 3, **dadurch gekennzeichnet, dass** die Potentialmessmittel eine Frequenztranspositionsschaltung mit einem Lokaloszillator (OSC) mit Frequenz $F_{OL}$ zum Transponieren der Messfrequenz $F_m$ auf eine Zwischenfrequenz $F_{IF} = F_m\text{-}F_{OL}$ und ein Tiefpassfilter (FLT) umfassen, das die Frequenz $F_{IF}$ durchlässt, aber die Frequenz $F_0\text{-}F_{OL}$ nicht.

5. Verfahren zum automatischen Anpassen der Impedanz einer Funkfrequenzemissions- oder -empfangskette, die mit einer Nennfrequenz $F_0$ arbeitet und wenigstens Folgendes umfasst: einen Verstärker (PA), eine Antenne (ANT), ein Impedanzanpassungsnetz (MN), das zwischen dem Verstärker und der Antenne angeordnet ist und justierbare Impedanzen umfasst, eine Messimpedanz ($C_a$) mit einem bekannten komplexen Wert, die in Serie zwischen dem Verstärker und dem Anpassungsnetz geschaltet ist, Mittel (CM) zum Messen von Potentialen (V1, V2), die an den Anschlüssen der Messimpedanz anliegen, um gleichzeitig den Strom in der Messimpedanz und eine Spannung am Ausgang des Verstärkers für eine Emissionskette oder eine Spannung am Eingang des Verstärkers für eine Empfangskette zu ermitteln, Mittel (DSP) zum Berechnen:

   - der komplexen Impedanz, die durch das Verhältnis zwischen der Spannung und dem Strom definiert wird, wobei diese komplexe Impedanz eine aktuelle Ladungs- oder Eingangsimpedanz des Verstärkers repräsentiert,
   - einer Impedanz der Antenne,
   - und von neuen Werten der justierbaren Impedanzen des Anpassungsnetzes, mit denen eine gewünschte Ladungs- oder Eingangsimpedanz für den Verstärker erhalten werden kann,

   und Mittel zum elektrischen Steuern des Anpassungsnetzes zum Justieren der justierbaren Impedanzen auf diese neuen Werte, wobei das Verfahren **gekennzeichnet ist durch** die folgenden Schritte: Injizieren einer Messfrequenz $F_m$, die sich von der Arbeitsfrequenz unterscheidet, in die Kette, Veranlassen des Messens von Potenzialen auf dieser Frequenz, und Durchführen von Impedanzberechnungen auf der Basis dieser Messungen unter Anwendung einer Korrektur, um die berechneten Impedanzen auf die Werte zu bringen, die sie für die Frequenz $F_0$ hätten.

## Claims

1. A radiofrequency transmit or receive chain working at a nominal frequency $F_0$, comprising at least one amplifier (PA), an antenna (ANT), an impedance matching network (MN) disposed between the amplifier and the antenna and comprising adjustable impedances, a measurement impedance ($C_a$) of known complex value inserted in series between the amplifier and the matching network, means (CM) of measurement of the potentials (V1, V2) present at the terminals of the measurement impedance for determining at one and the same time the current in the measurement impedance and a voltage at the output of the amplifier for a transmit chain or a voltage at the input of the amplifier for a receive chain, means of calculation (DSP)

   - of the complex impedance defined by the ratio of the voltage and the current, this complex impedance representing an existing load impedance or input impedance of the amplifier,
   - of an impedance of the antenna,
   - and of new values of the adjustable impedances of the matching network which make it possible to obtain a desired load impedance or input impedance for the amplifier,

   and means of electrical control of the matching network for adjusting the adjustable impedances to these new values, this chain being **characterized in that** it comprises a measurement frequency generator (GENFm) linked to the output of the transmit amplifier or to the input of the transmit amplifier, so as to inject thereinto a measurement frequency $F_m$ different from the working frequency $F_0$, the calculation means being designed to make impedance calculations on the basis of voltages and currents measured at the frequency $F_m$, by thereafter applying a correction so as to bring the calculated impedances to the values that they would have for the frequency $F_0$.

2. The transmit or receive chain as claimed in claim 1, **characterized in that** it comprises a bandpass filter (FPB) incorporated into the frequency generator or placed immediately downstream of the latter so as to allow only the measurement frequency $F_m$ to pass through to the remainder of the chain and to prevent the passage of signals at the frequency $F_0$ to the generator.

3. The transmit or receive chain as claimed in one of claims 1 and 2, **characterized in that** it comprises a bandstop filter (FCB) of known impedance characteristics inserted between the amplifier (PA) and the measurement impedance ($C_a$) so as to avoid the passage to the amplifier of signals at the frequency $F_m$.

4. The transmit or receive chain as claimed in one of claims 1 to 3, **characterized in that** the means for measuring potentials comprise a frequency transposition circuit with a local oscillator (OSC) with frequency $F_{OL}$ so as to transpose the measurement frequency $F_m$ to an intermediate frequency $F_{IF} = F_m - F_{OL}$ and a low-pass filter (FLT) allowing the frequency $F_{IF}$ to pass, but not the frequency $F_0 - F_{OL}$.

5. A method of automatic impedance matching of a radiofrequency transmit or receive chain working at a nominal frequency $F_0$ and comprising at least one amplifier (PA), an antenna (ANT), an impedance matching network (MN) disposed between the amplifier and the antenna and comprising adjustable impedances, a measurement impedance ($C_a$) of known complex value inserted in series between the amplifier and the matching network, means (CM) of measurement of the potentials (V1, V2) present at the terminals of the measurement impedance for determining at one and the same time the current in the measurement impedance and a voltage at the output of the amplifier for a transmit chain or a voltage at the input of the amplifier for a receive chain, means of calculation (DSP)

   - of the complex impedance defined by the ratio of the voltage and the current, this complex impedance representing an existing load impedance or input impedance of the amplifier,
   - of an impedance of the antenna
   - and of new values of the adjustable impedances of the matching network which make it possible to obtain a desired load impedance or input impedance for the amplifier,

   and means of electrical control of the matching network for adjusting the adjustable impedances to these new values,
   method **characterized in that** a measurement frequency $F_m$ differing from the working frequency is injected into the chain, the measurements of potentials are performed at this frequency, and the impedance calculations are made on the basis of these measurements by applying a correction so as to bring the calculated impedances to the values that they would have for the frequency $F_0$.

Fig. 3

Fig. 1

Fig. 2

**Fig. 4**

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090066440 A